# EUROPEAN PATENT APPLICATION

(11) **EP 4 750 229 A1**
(43) Date of publication of application: **27.05.2026**
(21) Application number: 24865766.0
(22) Date of filing: 05.09.2024
(51) Int. Cl.: H05K 1/14, H05K 1/02, H01R 12/73, H04M 1/02, H01R 12/77, H05K 9/00

(54) **CIRCUIT BOARD STRUCTURE COUPLED THROUGH CONNECTOR AND ELECTRONIC DEVICE INCLUDING SAME**

(30) Priority: 13.09.2023 KR 20230121539; 25.10.2023 KR 20230143922
(71) Applicant: Samsung Electronics Co., Ltd., Suwon-si, Gyeonggi-do 16677 (KR)
(72) Inventor: JEON, Jinhwan, Suwon-si Gyeonggi-do 16677 (KR)
(74) Representative: Gulde & Partner
(86) International application number: PCT/KR2024/013432
(87) International publication number: WO 2025/058325

(57) **Abstract**

Disclosed is a circuit board structure including a first circuit board and a second circuit board coupled through a first coupling member and a second coupling member. The circuit board structure may include openings which extend between the first circuit board and the second circuit board, and are configured to accommodate the plurality of coupling members. The coupling members may be configured to provide an electrical connection between the first coupling member and the second coupling member.

## Description

### TECHNICAL FIELD

Embodiments disclosed herein relate to a substrate structure coupled through a connector and an electronic device including the same.

### BACKGROUND

Electronic devices include various components. Typically, various electronic components may be mounted on a circuit board. For example, the circuit board may include a printed circuit board that includes a pattern of electrical paths. With miniaturization of electronic devices, space inside the electronic device may be reduced. As an internal space being reduced, a stacked circuit board structure may be utilized. For example, the stacked circuit board structure may include a printed board assembly. Typically, the stacked circuit board structure may include an interposer positioned between an upper substrate and a lower substrate and physically coupled with the upper substrate and the lower substrate through soldering.

The foregoing information may be provided as related art for the purpose of assisting in understanding the disclosure. No assertion or determination is made as to whether any of the foregoing may be applied as prior art with respect to the disclosure.

### DISCLOSURE

### TECHNICAL SOLUTION

A circuit board structure according to an embodiment disclosed herein may include a first circuit board including a first surface and a second circuit board including a second surface facing the first surface. The circuit board structure may include a plurality of first coupling members coupled to the first surface and a plurality of second coupling members coupled to the second surface and configured to be physically coupled with the plurality of first coupling members. The circuit board structure may include a frame extending between the first surface and the second surface and including a plurality of openings configured to accommodate the plurality of first coupling members and the plurality of second coupling members. The plurality of first coupling members and the second coupling members may be configured to provide an electrical connection between the first circuit board and the second circuit board.

An electronic device according to an embodiment disclosed herein may include the circuit board structure according to embodiments of the disclosure.

### BRIEF DESCRIPTION OF THE DRAWINGS

FIG. 1A illustrates a front perspective view of an electronic device in an unfolded state according to an embodiment.
FIG. 1B illustrates a rear view of an electronic device in an unfolded state according to an embodiment.
FIG. 1C illustrates a perspective view of an electronic device in a folded state according to an embodiment.
FIG. 1D illustrates an exploded perspective view of an electronic device according to an embodiment.
FIG. 2A illustrates a front view of a circuit board structure according to one embodiment.
FIG. 2B illustrates an exploded perspective view of a circuit board structure according to one embodiment.
FIG. 3A illustrates a front view of a first circuit board according to an embodiment.
FIG. 3B illustrates a front view of a second circuit board according to an embodiment.
FIG. 4 illustrates a connector according to an embodiment.
FIG. 5 illustrates a cross-sectional view of a circuit board structure according to an embodiment.
FIG. 6A illustrates a cross-sectional view of a circuit board structure including a shielding member according to one embodiment.
FIG. 6B illustrates a shielding member according to an embodiment.
FIG. 6C illustrates a shielding member according to an embodiment.
FIG. 6D illustrates a shielding member according to an embodiment.
FIG. 7 illustrates a circuit board structure including a connecting member according to an embodiment.
FIG. 8A illustrates a coupling structure of a connecting member according to an embodiment.
FIG. 8B illustrates a coupling structure of a connecting member according to an embodiment.
FIG. 9 illustrates a frame according to an embodiment.
FIG. 10 illustrates an exploded perspective view of a circuit board structure according to an embodiment.
FIG. 11 is a block diagram of an electronic device in a network environment according to various embodiments.

With regard to the description of the drawings, the same or similar components may be denoted by the same or similar reference numerals.

### DETAILED DESCRIPTION

Hereinafter, various embodiments of the present invention will be described with reference to the accompanying drawings. However, it should be understood that this is not intended to limit the present invention to a particular embodiment, and includes various modifications, equivalents, and/or alternatives of the embodiments of the present invention.

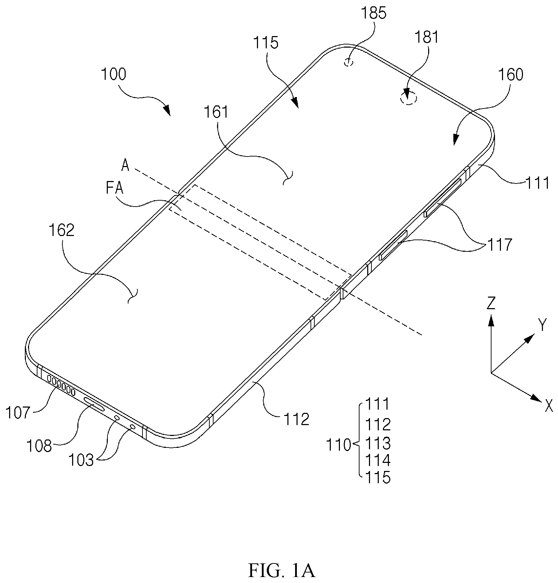

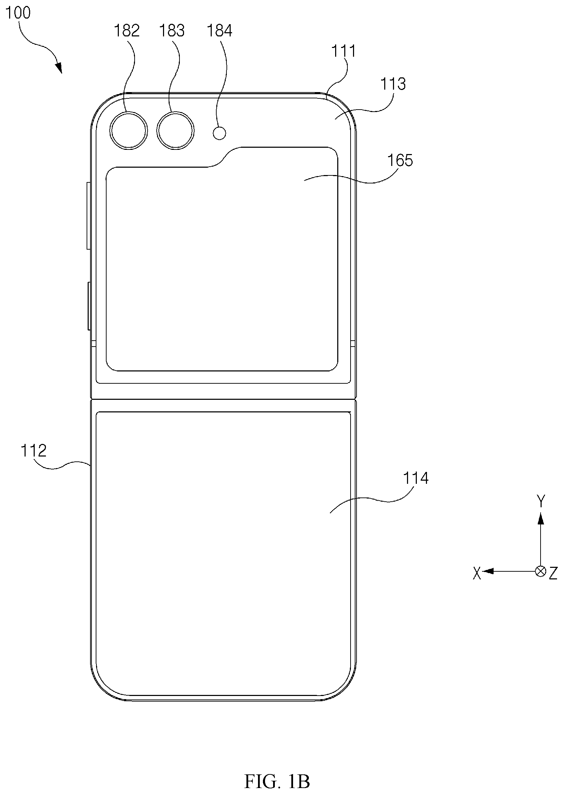

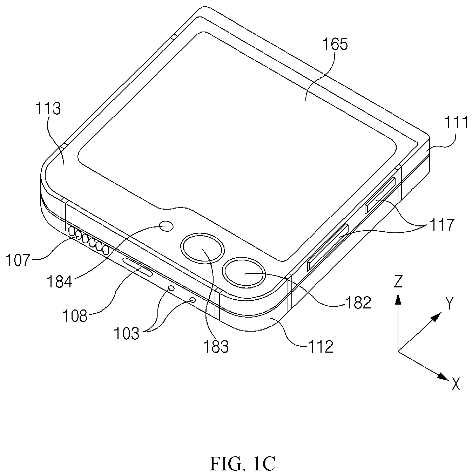

FIG. 1A illustrates a front perspective view of an electronic device in an unfolded state according to an embodiment. FIG. 1B illustrates a rear view of the electronic device in the unfolded state according to an embodiment, and FIG. 1C illustrates a perspective view of the electronic device in a folded state according to an embodiment.

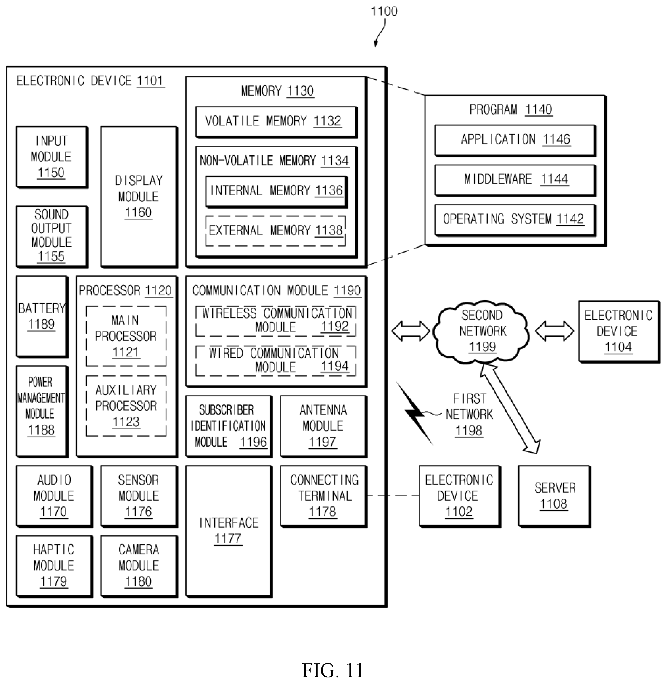

Referring to FIGS. 1A, 1B, and 1C, according to an embodiment, the electronic device 100 (e.g., the electronic device 1101 of FIG. 11) may be a foldable device in which at least a portion of a housing 110 may be folded. The electronic device 100 may be folded about a folding axis A. The unfolded state may be referred to as an open state or a flat state. For example, the unfolded state may include a case in which an angle between a first side member 111 and a second side member 112 is equal to or greater than a specified angle (e.g., about 120 degrees). A folded state may be referred to as a closed state. For example, the folded state may include a case in which an angle between the first side member 111 and second side member 112 is less than a specified angle (e.g., about 60 degrees).

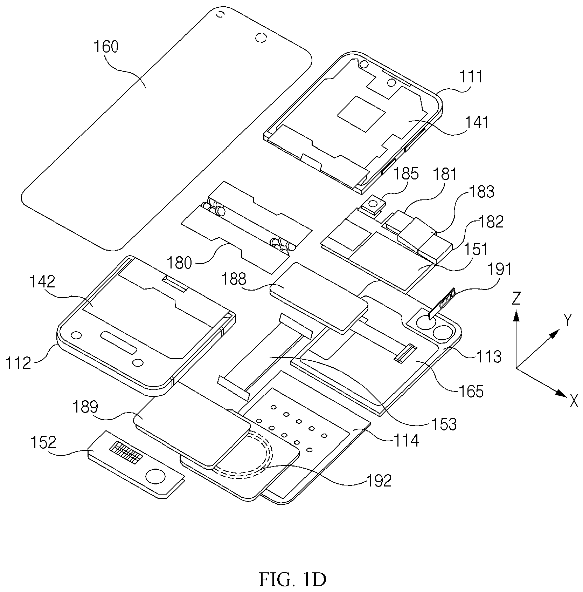

Referring to FIGS. 1A and 1B, the electronic device 100 (e.g., the electronic device 1101 of FIG. 11) according to an embodiment may include the housing 110 including a first surface (e.g., a front surface facing the +Z direction), a second surface (e.g., a rear surface facing the -Z direction), and a third surface (e.g., a side surface) surrounding a space between the first surface and the second surface. For example, the housing 110 of the electronic device 100 may include a front plate 115, a side member, and a rear plate. The side member may include the first side member 111 and the second side member 112, which are divided with respect to the folding axis A. The rear plate may include a first rear plate 113 and a second rear plate 114, which are divided with respect to the folding axis A. For example, the housing 110 may include a first housing and a second housing, which are divided with respect to the folding axis A. For example, the first housing may include a portion of the front plate 115 (e.g., the front plate 115 disposed in the +Y direction with respect to the folding axis A), the first side member 111, and the first rear plate 113. For example, the second housing may include a portion of the front plate 115 (e.g., the front plate 115 disposed in the -Y direction with respect to the folding axis A), the second side member 112, and the second rear plate 114. A hinge structure (e.g., the hinge structure 180 of FIG. 1D) may be disposed between the first housing and the second housing. The hinge structure may include any structure that allows the housing 110 to be folded or unfolded about the folding axis A.

The front plate 115 may be disposed on a first display 160 and may form at least a portion of the front surface of the electronic device 100. For example, the front plate 115 may be referred to as a glass plate, a glass layer, or a polymer plate. The first rear plate 113 and the second rear plate 114 may form at least a portion of the rear surface of the electronic device. For example, the first rear plate 113 and the second rear plate 114 may include coated or colored glass, ceramic, a polymer, a metal (e.g., aluminum, stainless steel, magnesium, or any alloy), or a combination of at least two of the above materials. The first side member 111 and the second side member 112 may form at least a portion of a side surface of the electronic device. For example, the first side member 111 and the second side member 112 may be coupled to the first rear plate 113 and the second rear plate 114, respectively. For example, the first side member 111 and the second side member 112 may include a metallic material (e.g., a conductive material) and/or a non-conductive material (e.g., a polymer). In an example, the first rear plate 113 and the first side member 111 may be integrally formed, and the second rear plate 114 and the second side member 112 may be integrally formed.

In an embodiment, the electronic device 100 may include at least one of the first display 160, a second display 165, camera modules 181, 182, and 183 (e.g., the camera module 1180 of FIG. 11), a key input device 117 (e.g., the interface 1177 of FIG. 11), a light emitting element 184, a speaker hole 107, a microphone hole 103, sensor circuitry 185, and a connector hole 108 (e.g., the interface 2177 of FIG. 12). For example, the electronic device 100 may omit at least one of the above components, or may additionally include another component.

Referring to FIGS. 1A and 1B, the electronic device 100 may include the first display 160 disposed to face a front surface (e.g., a surface facing the +Z direction) of the electronic device 100 in the unfolded state. The first display 160 may be viewable from the outside through at least a portion of the front plate 115. For example, the first display 160 may be disposed on a rear surface (e.g., a surface faces the -Z direction) of the front plate 115. In an example, the front plate 115 may be included in the first display 160. In an example, the first display 160 may include touch sensing circuitry, a pressure sensor, and/or a digitizer. In an example, the first display 160 may include a first display area 161 and a second display area 162, which may be distinguished by the folding axis A or a folding area FA. The folding area FA may be referred to as a display area of the first display 160 adjacent to the folding axis A.

In an example, at least one of an audio module (not illustrated), the sensor circuitry 185, the first camera module 181, and/or a light emitting element (not illustrated) may be disposed at a rear surface of the display 160. The sensor circuitry 185 may be configured to sense external information (e.g., illuminance and/or proximity) of the electronic device 100 through one area of the first display 160. The first camera module 181 may be configured to receive light through one area of the display 160 and obtain an image based on the received light.

The positions and numbers of the microphone hole 103 and the speaker hole 107 illustrated in FIGS. 1A and 1C are an example, and embodiments of the disclosure are not limited thereto. In an embodiment, the speaker hole 107 may include a receiver hole (not illustrated) for a call.

Referring to FIG. 1C, the electronic device 100 may include a second display 165 disposed to face a front surface (e.g., a surface facing the +Z direction) of the electronic device 100 in the folded state. The second display 165 may be disposed on at least a portion of the first rear plate 113. In an example, the second display 165 may include touch sensing circuitry, a pressure sensor, and/or a digitizer.

Referring to FIG. 1C, the electronic device 100 may include a second camera module 182 and/or a third camera module 183 disposed to face the front surface of the electronic device 100 in the folded state. The second camera module 182 and the third camera module 183 may have, for example, different fields of view (FOVs), zoom magnifications, or functions. The electronic device 100 may include a light emitting element 184 disposed to face the front surface of the electronic device 100 in the folded status. In the example of FIGS. 1B and 1C, two camera modules are illustrated at the first rear plate 113, but embodiments of the disclosure are not limited thereto. The electronic device 100 may comprise one or more camera modules located at the first rear plate 113.

Although not illustrated in FIGS. 1A to 1C, the electronic device 100 may be configured to have an intermediate state between the folded state and the unfolded state. For example, the intermediate state may be referred to as a flex state. The mode of the electronic device 100 in the intermediate state may be referred to a table mode or a flex mode. In the intermediate state, an angle between the first side member 111 and the second side member 112 may be within a specified range (e.g., about 60 degrees or more and less than about 120 degrees).

In the examples of FIGS. 1A, 1B, and 1C, the electronic device 100 is illustrated as an in-fold device in which the first display 160 is folded to face each other in the folded state. However, embodiments of the disclosure are not limited thereto. For example, the electronic device 100 may be an out-fold device in which the first display 160 is folded to face the outside in the folded state.

FIG. 1D illustrates an exploded perspective view of an electronic device according to an embodiment.

Referring to FIG. ID, the electronic device 100 according to an embodiment may include the first display 161, the first side member 111, the second side member 112, the first rear plate 113, and the second rear plate 114. For example, at least a portion of the first display area 161, the first side member 111, the second side member 112, the first rear plate 113, or the second rear plate 114 may define an external appearance of the electronic device 100.

In an example, the first side member 111 may be coupled to or include the first support member 141. The first support member 141 may be formed of a metallic material and/or a non-metallic (e.g., polymer) material. The first support member 141 is coupled to the first side member 111 that forms the appearance of the electronic device 100, and may be referred to as at least a portion of the first side member 111 that is not visible from the outside of the electronic device 100. The first support member 141 can be configured to support components inside the electronic device 100. For example, the first display 160 may be coupled to a first surface (e.g., a surface facing the +Z direction) of the first support member 141, and at least one of the first circuit board 151 and a first battery 188 may be disposed at a second surface (e.g., a surface of the first support member 141 facing the -Z direction).

In an example, the second side member 112 may be coupled to or include a second support member 142. The second support member 142 may be formed of a metallic material and/or a non-metallic (e.g., polymer) material. The second support member 142 is coupled to the second side member 112 that forms the appearance of the electronic device 100, and may be referred to as at least a portion of the second side member 112 that is not visible from the outside of the electronic device 100. The second support member 142 can be configured to support components inside the electronic device 100. For example, the first display 160 may be coupled to a first surface (e.g., a surface facing the +Z direction) of the second support member 142, and at least one of the second circuit board 152 and the second battery 189 may be disposed at a second surface (e.g., a surface facing the -Z direction) of the second support member 142.

The electronic device 100 may include a hinge structure 180. For example, the hinge structure 180 may be physically coupled to the first side member 111 (e.g., the first support member 141) and the second side member 112 (e.g., the second support member 142). The hinge structure 180 may be configured to be folded about at least one folding axis. For example, the first side member 111 and the second side member 112 may be folded or unfolded about the hinge structure 180.

The electronic device 100 may include the first circuit board 151 and the second circuit board 152. The first circuit board 151 may be electrically connected to the second circuit board 152 through a connecting member 153. In an embodiment, a processor (e.g., the processor 1120 of FIG. 11), memory (e.g., the memory 1130 of FIG. 11), and/or an interface may be mounted at the first printed circuit board 151 or the second circuit board 152. Various components of the electronic device 100 may be mounted at the first circuit board 151 or the second circuit board 152. For example, at least some of the components of the electronic device 1101 described below with reference to FIG. 11 may be mounted on at least one of the first circuit board 151 or the second circuit board 152.

The electronic device 100 may include at least one antenna and/or an antenna module for transmitting and receiving wireless signals. For example, the electronic device 100 may include an antenna corresponding to at least a portion of the first side member 111 and/or the second side member 112. For example, the electronic device 100 may include a rear substrate 192. The rear substrate 192 may include a near field communication (NFC) antenna, a wireless charging antenna, and/or a magnetic secure transmission (MST) antenna. For example, the electronic device 100 may include an antenna module 191. The antenna module 191 may be configured to transmit and receive signals in new radio 2 (NR2) frequency bands.

The electronic device 100 may include at least one battery (e.g., the first battery 188 and/or the second battery 189). The at least one battery may supply power to at least one component of the electronic device 100. The at least one battery may include, for example, a non-rechargeable primary battery, a rechargeable secondary battery, or a fuel cell. The first battery 188 and/or second battery 189 may be integrally disposed in the electronic device 100, or may be disposed detachably from the electronic device 100.

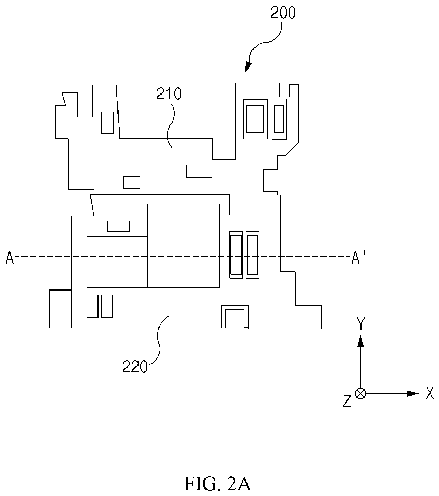

FIG. 2A illustrates a front view of a circuit board structure according to one embodiment.

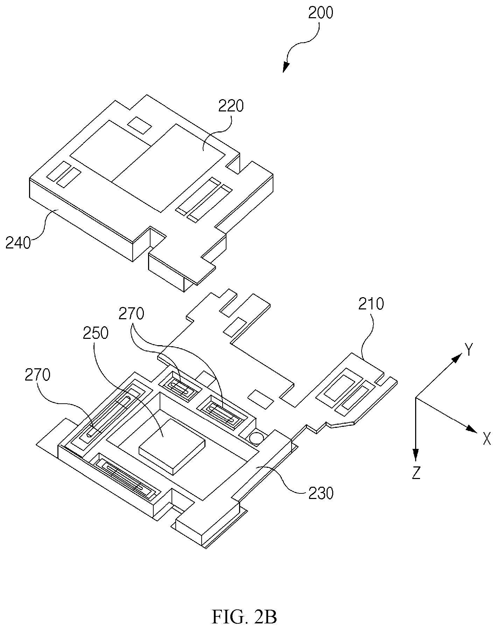

FIG. 2B is illustrates an exploded perspective view of a circuit board structure according to one embodiment.

Referring to FIGS. 2A and 2B, according to an embodiment, the circuit board structure 200 may include a first circuit board 210 and a second circuit board 220. For example, the second circuit board 220 may be stacked on at least a portion of the first circuit board 210. The first circuit board 210 and the second circuit board 220 may be configured to be detachable from each other.

For example, the circuit board structure 200 may be referred to as a printed board assembly or a stacked circuit board structure. In an example, the circuit board structure 200 may be included in an electronic device (e.g., the electronic device 100 of FIGS. 1A to 1D). The circuit board structure 200 may correspond to the first printed circuit board 151 or the second circuit board 152 in FIG. 1D.

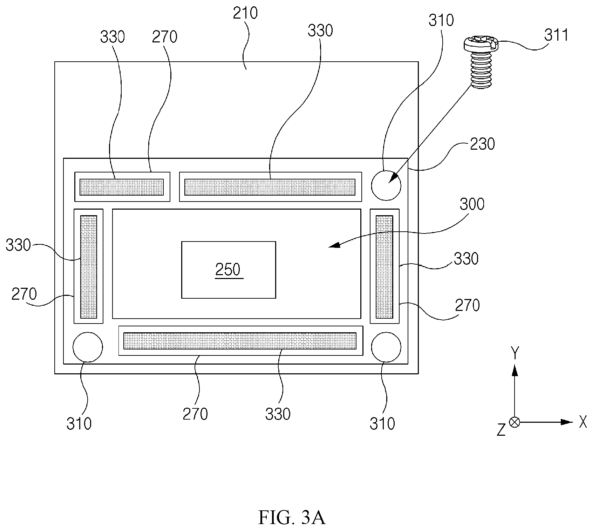

The first circuit board 210 may include first coupling members (e.g., the first coupling member 330 of FIG. 3A) disposed on a first surface (e.g., a surface facing the -Z direction or a surface facing the second circuit board 220). The first circuit board 210 may include a first frame 230 disposed on the first surface. The first frame 230 may include a plurality of openings 270 configured to accommodate the first coupling members. For example, a first component 250 may be disposed on the first surface of the first circuit board 210. The first component 250 may include any electrical component (e.g., a power management integrated circuit (PMIC), an application processor (AP), a transceiver, a communication processor (CP), memory, and/or at least one chip) electrically connected with the first circuit board 210. A configuration of the first circuit board 210 may be described below with respect to FIG. 3A.

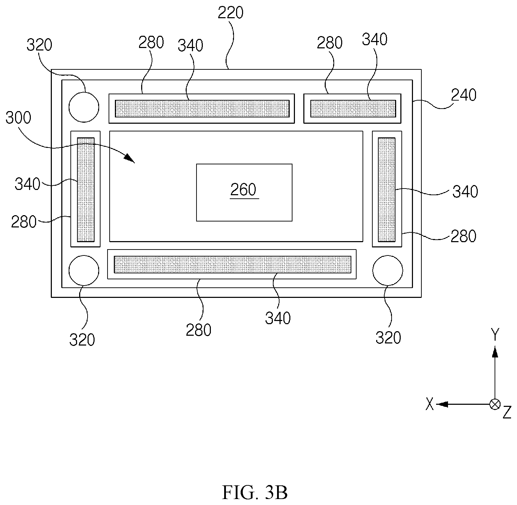

The second circuit board 220 may include second coupling members (not shown) disposed on a second surface (e.g., a surface facing the +Z direction or a surface facing the first circuit board 210). The second circuit board 220 may comprise a second frame 240 disposed on the second surface. The second frame 240 may comprise a plurality of openings configured to accommodate the second coupling members (not shown). For example, a second component (not shown) may be disposed on the second surface of the second circuit board 220. The second component (not shown) may comprise any electrical component (e.g., a PMIC, an AP, a transceiver, a CP, memory, and/or at least one chip) electrically connected with the second circuit board 220. A configuration of the second circuit board 220 may be described below with respect to FIG. 3B.

In the example of FIG. 2B, the frames 230 and 240 and the coupling members are described as being separated from each other, but embodiments of the disclosure are not limited thereto. For example, the frames may include the coupling members. For example, the first frame 230 may be integrally formed with the first coupling member.

FIG. 3A illustrates a front view of a first circuit board according to an embodiment.

Referring to FIG. 3A, according to an embodiment, the first circuit board 210 may include the first frame 230 disposed on the first surface. The first frame 230 may include a plurality of openings 270. At least some of the plurality of openings 270 may be configured to accommodate the first coupling member 330. The plurality of openings 270 can be formed such that the first coupling member 330 is seated on the first surface of the first circuit board 210. For example, when the first surface is viewed downward from above the first surface, each of the plurality of openings 270 may surround at least a portion of a periphery of the first coupling members 330 and include a wall protruding in a direction perpendicular to the first surface.

An inner space 300 may be formed at the first circuit board 210. The inner space 300 may be referred to as a space surrounded by the first surface of the first circuit board 210 and the first frame 230. For example, at least a portion of the inner space 300 may be surrounded by an inner wall of the first frame 230 (e.g., a wall of the first frame 230 adjacent to the inner space 300). The first frame 230 may include an inner wall formed along a circumference of the inner space 300. At least a portion of an outer wall of the first frame 230 may be omitted from the first frame 230. The shape of the first frame 230 illustrated in FIG. 3A is an example, and embodiments of the disclosure are not limited thereto. For example, at least some of the plurality of openings 270 may be omitted from the first frame.

In an example, the first frame 230 may include at least one coupling hole 310. The coupling hole 310 may include a connecting member 311 configured to couple the first frame 230 to the first circuit board 210. For example, the connecting member 311 may physically couple the first frame 230 to a first circuit board 210. The connecting member 311 may include, for example, a screw, a rivet, and/or a coupler.

In one example, the first frame 230 may be coupled to the first circuit board 210 via soldering. The first frame 230 may be couple to the first circuit board 220 via, for example, surface mounting device (SMD) soldering. In one example, the first coupling member 330 may be couple to the first circuit board 210 via the SMD soldering. The plurality of first coupling members 330 may be self-aligned on the first circuit board 210 via a reflow process. When the plurality of first coupling members 330 are soldered, a process variation may be generated in the coupling position of the plurality of first coupling members 330. In one example, the first frame 230 may be used as a guide of the first coupling members 330. The openings 270 of the first frame 230 may guide the coupling position for the first coupling members 330 by surrounding at least a portion of perimeter of the first coupling members 330. Using the first frame 230, the process variation for the coupling position of the first coupling members 330 may be reduced.

In an example, the first frame 230 may include the first coupling members 330. The first frame 230 may be integrally formed with the first coupling members 330. Through soldering, the first frame 230 including the first coupling members 330 may be coupled on the first board 210.

FIG. 3B illustrates a front view of a second circuit board according to an embodiment.

Referring to FIG. 3B, according to an embodiment, the second circuit board 220 may include a second frame 240 disposed on the second surface. The second frame 240 may include a plurality of openings 280. At least some of the plurality of openings 280 may be configured to accommodate the second coupling members 340. The plurality of openings 280 may be formed such that the second coupling members 340 are seated on the second surface of the second circuit board 220. For example, when the second surface is viewed downward from above the second surface, each of the plurality of openings 280 may include a wall that surrounds at least a portion of a periphery of the second coupling members 340 and protrudes in a direction perpendicular to the second surface.

The inner space 300 may be formed at the second circuit board 220. The inner space 300 may be referred to as a space enclosed by the second surface of the second circuit board 220 and the second frame 240. For example, at least a portion of the inner space 300 may be enclosed by an inner wall of the second frame 240 (e.g., a wall of the second frame 240 adjacent to the inner space 300). The second frame 240 may include the inner wall formed along a circumference of the inner space 300. At least a portion of an outer wall of the second frame 240 may be omitted from the second frame 240. The shape of the second frame 240 illustrated in FIG. 3B is an example, and embodiments of the disclosure are not limited thereto. For example, at least some of the plurality of openings 280 may be omitted from the second frame 240.

In an example, the second frame 240 may include at least one coupling hole 320. The coupling hole 320 may include a connecting member (e.g., the connecting member 311 of FIG. 3A) configured to couple the second frame 240 to the second circuit board 220. For example, the connecting member may physically couple the second frame 240 to the second circuit board 220. The connecting member may include, for example, a screw, a rivet, and/or a coupler.

In one example, the second frame 240 may be coupled to the second circuit board 220 via soldering. The second frame 240 may be couple to the second circuit board 220 via, for example, SMD soldering. In one example, the second coupling members 340 may be couple to the second circuit board 220 via SMD soldering. The plurality of second coupling members 340 may be self-aligned on the second circuit board 220 via a reflow process. In one example, the second frame 240 may be utilized as a guide of the second coupling members 340. The openings 280 of the second frame 240 may guide the coupling positions for the second coupling members 340 by surrounding at least a portion of the perimeter of the second coupling members 340. Using the second frame 240, process variations for the coupling positions of the second coupling members 340 may be reduced.

In an example, the second frame 240 may include the second coupling members 340. The second frame 240 may be integrally formed with the second coupling members 340. Through soldering, the second frame 240 including the second coupling members 340 may be coupled on the second board 220.

Referring to FIGS. 2A to 3B, according to an embodiment, the first circuit board 210 and the second circuit board 220 may be physically coupled to each other through the first coupling members 330 and the second coupling members 340. The first coupling members 330 and second coupling members 340 may include connectors (e.g., a board-to-board connector) configured to be detachable from each other. For example, a first coupling member 330 may include a connector of a first gender, and a second coupling member 342 may include a connector of a second gender. Since the first circuit board 210 and the second circuit board 220 are coupled to each other through the connectors, repair of the circuit board structure 200 may become easier. For example, repair and/or replacement of only the first circuit board 210 or only the second circuit board 220 may be performed.

The first circuit board 210 and the second circuit board 220 may be electrically connected through a first coupling member 330 and a second coupling member 340. The first coupling member 330 may include a plurality of first pins electrically connected to the first circuit board 210. The second coupling member 340 may include a plurality of second pins electrically connected to the second circuit board 220. When the first coupling member 330 and the second coupling member 340 are coupled, the plurality of first pins and the plurality of second pins may be electrically connected.

When the first circuit board 210 and the second circuit board 220 are coupled via the first coupling member 330 and the second coupling member 340, the first frame 230 and the second frame 240 may be in physical contact. The first frame 230 and the second frames 240 may form, for example, one frame. The frame may extend between the first surface of the first circuit board 210 and the second surface of the second circuit board 220. In one example, the first frame 230 and second frame 240 may include a guide structure for guiding the coupling. The second frame 240 may include, for example, a protrusion formed on a surface facing the first frame 230. The second frame 230 may include a groove formed on a surface facing the second frame 240 and configured to accommodate the protrusion of the second frame 240.

In an embodiment, the first frame 230 and the second frame 240 may be configured to provide shielding for the inner space 300. The inner space 300 may be referred to as a space enclosed by the first surface of the first circuit board 210, the second surface of the second circuit board 220, the first frame 230, and the second frame 240. For example, at least a portion of the first frame 230 and the second frame 240 may be formed of a conductive material, and at least a portion of the conductive material may be electrically connected to a ground region of the circuit board structure 200. The first frame 230 and the second frames 240 may be configured to provide electrical and/or magnetic shielding for components (e.g., 250 and 260) located in the inner space.

In an embodiment, the circuit board structure 200 may include a conductive member disposed on at least a portion of surfaces of the first frame 230 and the second frame 240 facing the inner space 300. For example, the conductive member may be formed, through plating, on at least a portion of the surfaces of the first frame 230 and the second frame 240 facing the inner space 300. At least a portion of the conductive member may be electrically connected to a ground region of the circuit board structure 200. The conductive member may be configured to provide electrical and/or magnetic shielding for components located in the inner space 300.

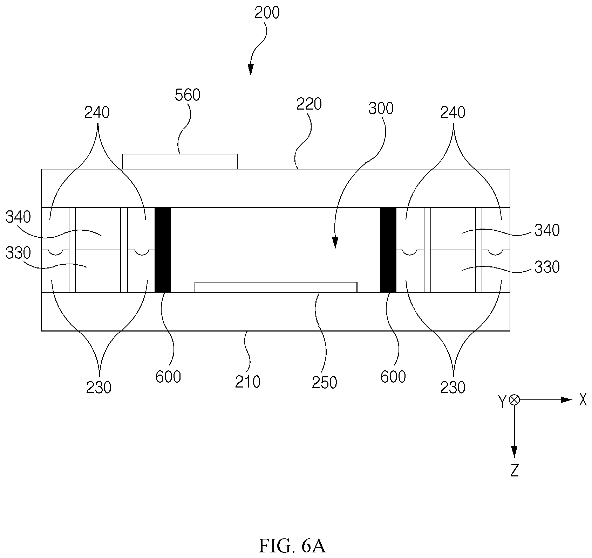

In one embodiment, as described below with respect to FIGS. 6A to 6D, the circuit board structure 200 may further include a separate shielding member. The circuit board structure 200 may include a shielding member disposed adjacent to at least a portion of surfaces of the first frame 230 and the second frame 240 facing the inner space 300. For example, at least a portion of the shielding member may be electrically connected to a ground region of the circuit board structure 200. The shielding member may be configured to provide electrical and/or magnetic shielding for components located at the inner space 300.

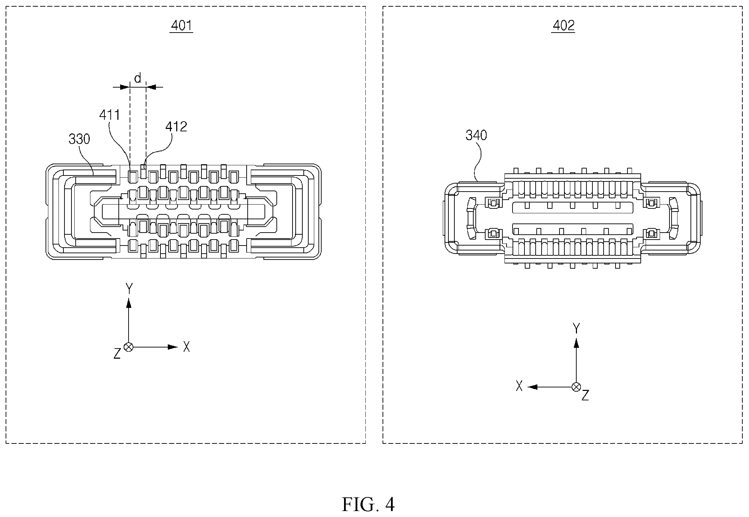

FIG. 4 illustrates a connector according to an embodiment.

Referring to FIG. 4, an example of the first coupling member 330 of FIG. 3A and the second coupling member 340 of FIG. 3B may be described. Referring to reference numeral 401, the first coupling member 330 may include a connector of a first gender including a plurality of pins. For example, a distance d between the first pin 411 and the second pin 412 among the plurality of pins may be less than a specified distance (about 0.175 mm). Referring to reference numeral 402, the second coupling member 340 may include a connector of a second gender including a plurality of pins. A shape and the distance d of the first coupling member 330 and the second coupling member 340 illustrated in FIG. 4 are an example, and embodiments of the disclosure are not limited thereto.

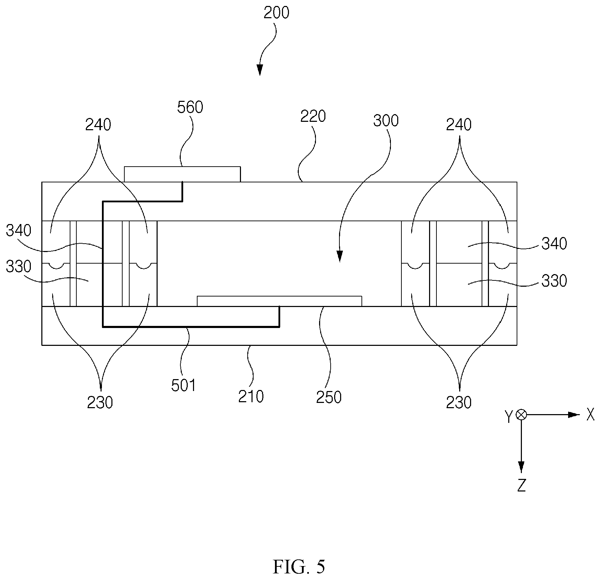

FIG. 5 illustrates a cross-sectional view of a circuit board structure according to an embodiment.

Referring to FIG. 5, a cross-sectional view of the circuit board structure 200 along line A-A' of FIG. 2A is shown. As described above, the first circuit board 210 and the second circuit board 220 may be electrically connected through first coupling members 330 and second coupling members 340. For example, a component 250 located at the first circuit board 210 of the inner space 300 may be electrically connected with a component 560 located at the second circuit board. For example, the component 250 and the component 560 may be electrically connected through an electrical path 501. At least a portion of the electrical path 501 may pass through the first coupling member 330 and the second coupling member 340.

FIG. 6A illustrates a cross-sectional view of a circuit board structure including a shielding member according to one embodiment.

Referring to FIG. 6A, a cross-sectional view of the circuit board structure 200 along line A-A' of FIG. 2A is shown. According to one embodiment, the circuit board structure 200 may further include shielding members 600. For example, the shielding members 600 may include a conductive member configured to provide electrical and/or magnetic shielding for the inner space 300. The shielding members 600 may be electrically connected with a ground region of the circuit board structure 210 at least one point.

In an embodiment, the shielding member 600 may be located adjacent to an inner wall of a frame (e.g., the first frame 230 and the second frame 240). In an example, the shielding members 600 may be attached to an inner wall of the frame. The shielding members 600 may include a conductive tape. For example, the shielding members 600 may include a first conductive tape attached to the inner wall of the first frame 230 and a second conductive tape attached to the innerwall of the second frame 240. In an example, the shielding members 600 may be attached to the inner walls of the frames through plating.

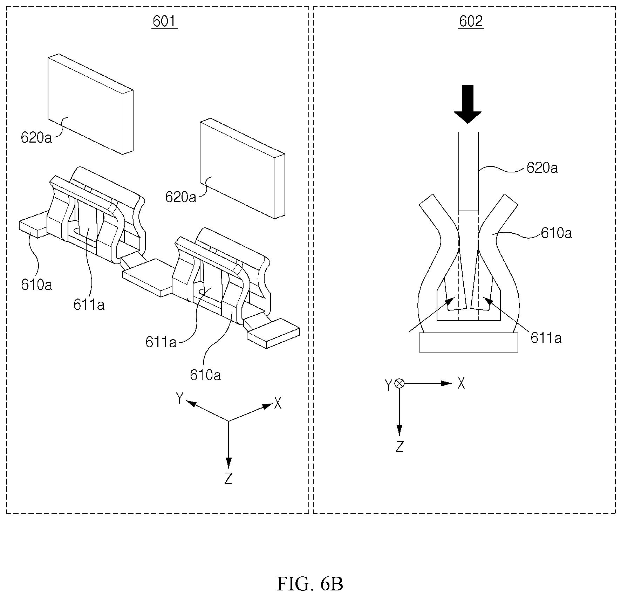

The form of the shielding member 600 described above with respect to FIG. 6A is exemplary, and embodiments of the disclosure are not limited thereto. Various examples of the shielding members 600 may be described with respect to FIGS. 6B to 6D.

FIG. 6B illustrates a shielding member according to an embodiment.

Referring to FIGS. 6A and 6B, the shielding members 600 may include a metallic clip. For example, referring to reference number 601, a shielding member 600 can include a clip 610a and a plate 620a. For example, the clip 610a can be located on the first circuit board 210 of FIG. 2A, and the plate 620a can be located on the second circuit board 220 of FIG. 2A.

Referring to reference numeral 602, the clip 610a may include a holder 611a configured to apply a force in an inward direction of the clip 610a. The holder 611a may be configured to fix the plate 620a when the clip 610a is coupled with the plate 620a.

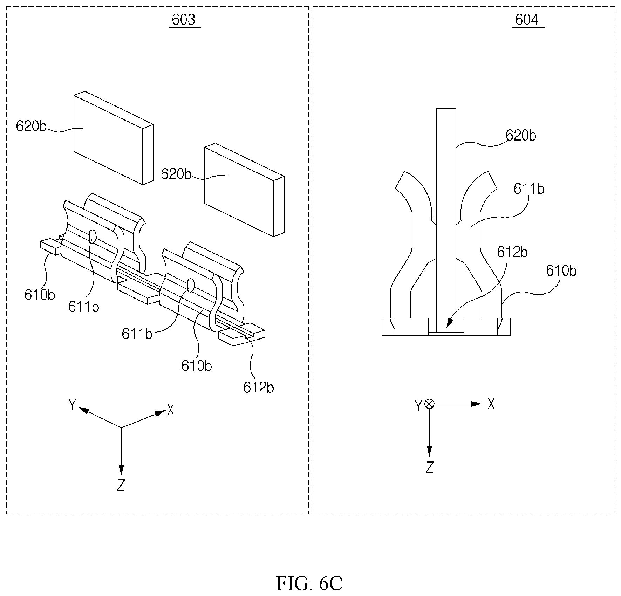

FIG. 6C illustrates a shielding member according to an embodiment.

Referring to FIGS. 6A and 6C, the shielding members 600 may include a metallic clip. For example, referring to reference number 603, the shielding members 600 may include a clip 610b and a plate 620b. For example, the clip 610b can be located at the first circuit board 210 of FIG. 2A, and the plate 620b can be located at the second circuit board 220 of FIG. 2A.

Referring to reference numeral 604, the clip 610b may include a protrusion 611b protruding inward of the clip 610b. The protrusion 611b may be configured to fix the plate 620b when the clip 610b is coupled with the plate 620b.

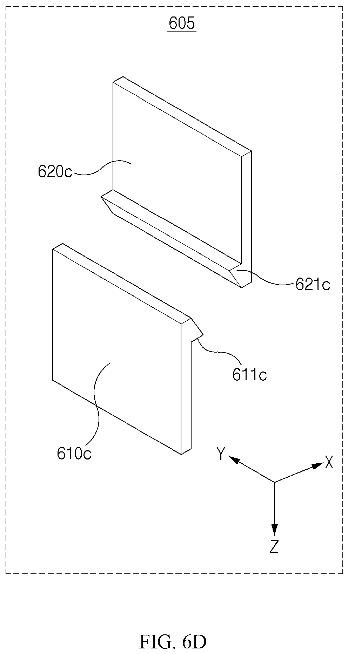

FIG. 6D illustrates a shielding member according to an embodiment.

Referring to FIGS. 6A and 6D, the shielding members 600 may include metallic plates. For example, referring to reference number 605, it may include a first plate 610c and a second plate 620c. For example, the first plate 610c may be located at the first circuit board 210 of FIG. 2A, and the second plate 620c may be located at the second circuit board 220 of FIG. 2A.

The first plate 610c may include a first protrusion 611c, when coupled, formed to protrude in a direction toward the second plate 620c. The second plate 620c may include a second protrusion 621c, when coupled, formed to protrude in a direction toward the first plate 610c. The first protrusion 611c and the second protrusion 621c may be configured to, when coupled, reduce a probability that the first plate 610c is separated from the second plate 620c.

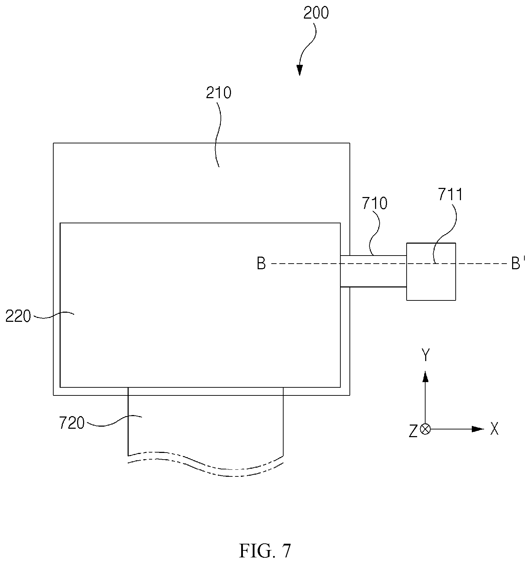

FIG. 7 illustrates a circuit board structure including a connecting member according to an embodiment.

According to an embodiment, the circuit board structure 200 may include at least one connecting member. For example, the circuit board structure 200 may include a connecting member 710 connected to an electrical element 711 at one end and connected to the first circuit board 210 or the second circuit board 220 at the other end. The connecting member 710 may include, for example, a flexible printed circuit board (FPCB). The connecting member 710 may, for example, include at least one first electrical path electrically connected between the first circuit board 210 and the second circuit board 220. The connecting member 710, for example, may include at least one second electrical path that electrically connects the electrical element 711 to the first circuit board 210 and/or the second circuit board 220.

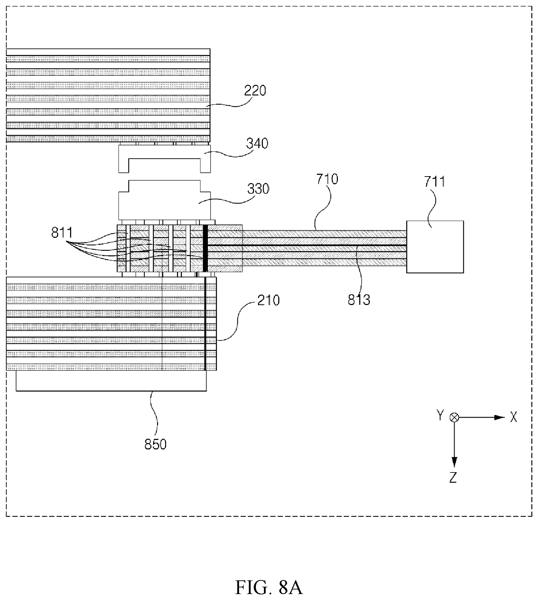

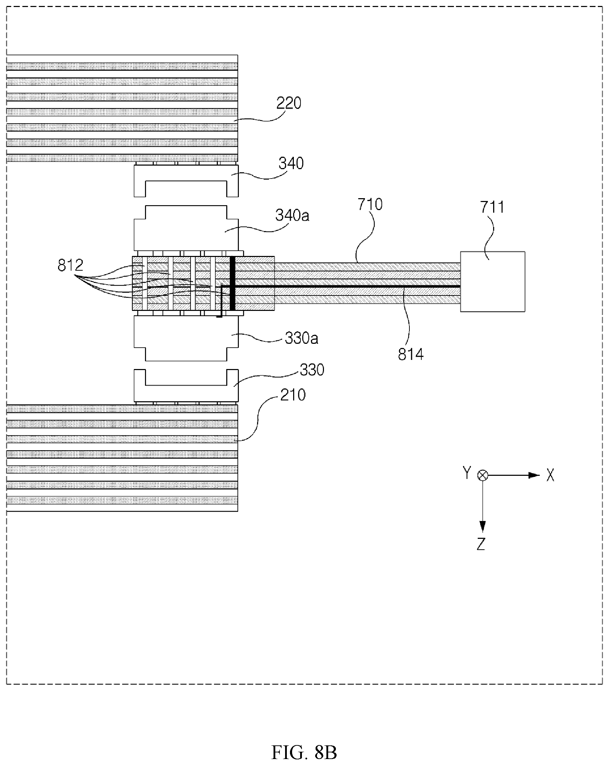

According to an embodiment, the connecting member 710 may be integrally formed with the coupling member. For example, as described below with respect to FIGS. 8A and 8B, the connecting member may can include at least one coupling member. By including the coupling member, the number of connectors for connecting the connecting member 710 may be reduced. In the examples of FIGS. 8A and 8C described below, the frame and the shielding member may be omitted for ease of description. Those ordinary skilled in the art will understand that the frame and/or the shielding member may be included in the circuit board structure 200, as described above with respect to FIGS. 2A to 6D.

FIG. 8A illustrates a coupling structure of a connecting member according to an embodiment.

Referring to FIGS. 7 and 8A, a cross-sectional view of the circuit board structure 200 along line B-B' of FIG. 7 is illustrated. According to an embodiment, one end of the connecting member 710 may be coupled to the circuit board structure 200. At least a portion of one surface (e.g., a surface facing the +Z direction) of the connecting member 710 may be coupled to a first surface (e.g., a surface of the -Z direction) of the first circuit board 210. For example, the connecting member 710 may be coupled to the first circuit board 210 through soldering.

In an example, the connecting member 710 may include at least one first electrical path 811 located between the first circuit board 210 and the first coupling member 230. The at least one first electrical path 810 may electrically connect the first circuit board 210 and a first coupling member 330 (e.g., a plurality of pins of the first coupling member 330). In an example, the at least one first electrical path 811 may include at least one through-hole (e.g., a via) formed through the connecting member 710. The through-hole may be formed through a plurality of layers of the connecting member 710. At least one first electrical path 811 may be formed by filling a conductive material (e.g., copper) in the at least one through-hole. For example, the at least one first electrical path may be formed by performing copper plating on the at least one through-hole using a laser.

In an example, the connecting member 710 may include at least one second electrical path 813 that electrically connects the electrical element 711 with the first circuit board 210. For example, the at least one second electrical path 813 may electrically connect the electrical element 711 with an electrical element 850 disposed at the first circuit board 210.

In the example of FIG. 8A, the first coupling member 330 and the second coupling member 340 may be used for coupling to the first circuit board 210 and the second circuit board 220. A separate connector for connecting the connecting member 710 to the first circuit board 210 or the second circuit board 220 may not be required. By directly connecting the connecting member 710 to the first circuit board 210, and forming at least one first electrical path 811 for the first coupling member 330 in the connecting member 710, the size of the circuit board structure 200 may be reduced.

In the example of FIG. 8A, it has been described that the electrical element 711 is electrically connected with the electrical element 850 disposed at the first circuit board 210, but embodiments of the disclosure are not limited thereto. In an embodiment, the electrical element 711 may be electrically connected with an electrical element (not shown) disposed at the second circuit board 220. In an example, the electrical element 711 may be electrically connected to at least one pin of the first coupling member 330. The electrical element 711 may be electricaly connected to the second circuit board 220 via the first coupling member 330. In an example, the electrical element 710 may be electrically connected to the first electrical path 811. As described above, the first electrical path 811 may be configured to provide an electrical path between the first circuit board 210 and the second circuit board 220 via first coupling member 330. Via the first electrical path 811, the electrical element 711 may be connected to the first circuit board 210 and to the second circuit board 220.

FIG. 8B illustrates a coupling structure of a connecting member according to an embodiment.

Referring to FIGS. 7 and 8B, a cross-sectional view of the circuit board structure 200 along line B-B' of FIG. 7 is illustrated. According to an embodiment, one end of the connecting member 710 may be coupled to the circuit board structure 200. For example, the connecting member 710 may include a third coupling member 330a and a fourth coupling member 340b coupled at the one end. An electrical element 711 may be coupled to the other end of the connecting member 710.

The third coupling member 330a may be disposed on one surface (e.g., a surface facing the +Z direction) of the connecting member 710. The fourth coupling member 340b may be disposed on an opposite surface (e.g., a surface of the connecting member 710 facing the -Z direction). For example, the third coupling member 330a and the fourth coupling member 340 may be coupled to the connecting member 710 through soldering. The third coupling member 330a is configured to be physically and electrically coupled to the first coupling member 330. The fourth coupling member 340 is configured to be physically and electrically coupled to the second coupling member 340.

In an example, the connecting member 710 may include at least one first electrical path 812 positioned between the third coupling member 330a and the fourth coupling member 340a. The at least one first electrical path 8121 may electrically connect the third coupling member 330a and the fourth coupling member 240a. In an example, the at least one first electrical path 812 may include at least one through-hole (e.g., a via) formed through the connecting member 710. The through-hole may be formed through a plurality of layers of the connecting member 710. At least one first electrical path 812 may be formed by filling a conductive material (e.g., copper) in the at least one through-hole. For example, the at least one first electrical path 812 may be formed by plating copper on the at least one through-hole using a laser.

In an example, the connecting member 710 may include at least one second electrical path 814 that electrically connects the electrical element 711 with the third coupling member 330a. The at least one second electrical path 814 shown in FIG. 8B is an example, and embodiments of the disclosure are not limited thereto. For example, the at least one second electrical path 814 may electrically connect the electrical element 711 with the third coupling member 330a and/or the fourth coupling member 340a. For example, the second electrical path 814 may be electrically connected to the first electrical path 812. Through the first electrical path 812, the second electrical path 814 may be electrically connected to the first circuit board 210 and the second circuit board 220. The electrical element 711 may be electrically connected to the first and second circuit boards 210 and 220 through the second electrical path 814.

In the example of FIG. 8B, the connecting member 710 may be detachably coupled with the first circuit board 210 and the second circuit board 220 through the third coupling member 330a and the fourth coupling member 340a. Since the connecting member 710 is coupled through connectors, the connecting member 710 can be easily replaced. In addition, since the third coupling member 330a and the fourth coupling member 340a are located at the connecting member 710, the size of the circuit board structure 200 can be reduced.

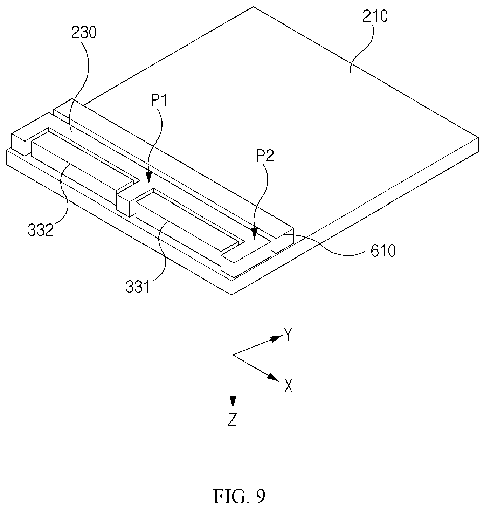

FIG. 9 illustrates a frame according to an embodiment.

Referring to FIG. 9, according to one embodiment, the circuit board structure 200 may include a frame in various forms. In the examples of FIGS. 2A to 3B, the frame is illustrated as having an opening shaped to surround a peripheral portion of the coupling member. However, according to one example, the opening of the frame may have a shape to surround at least two sides of the coupling member.

For example, the first frame 230 may include openings set to accommodate the (1-1)-th coupling member 331 (e.g., the first coupling member 330) and the (1-2)-th coupling member 332 (e.g., the first couplings member 330). For example, the first frame 230 may include a sidewall formed to protrude from an inner wall (e.g., a surface adjacent to the first shielding member 610) of the first frame 230. For example, the first frame 232 may include a first sidewall formed to protrude from a first point P1 of the inner wall in an outward direction (e.g., the -Y direction) of the circuit board structure 200 and a second sidewall formed to protrude from a second point P2 of the inner wall in the outward direction. For example, the first sidewall, the inner wall, and the second sidewall may be referred to as openings configured to accommodate the (1-2)-th couplings member 331.

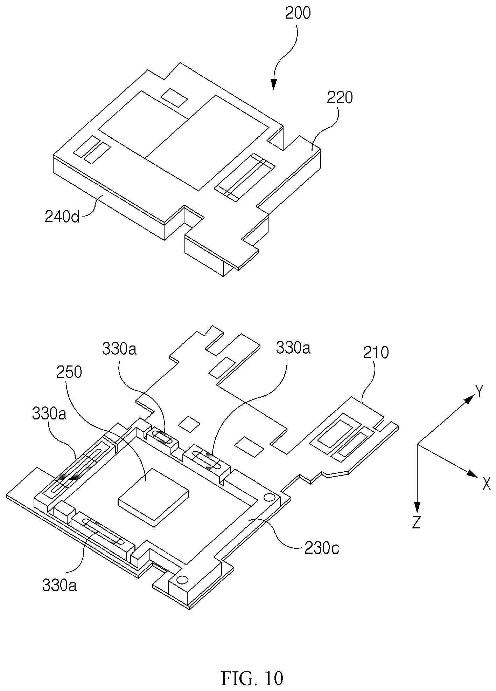

FIG. 10 illustrates an exploded perspective view of a circuit board structure according to an embodiment.

Referring to FIG. 10, according to an embodiment, the circuit board structure 200 may include a frame integrally formed with the coupling member. With respect to FIGS. 2A to 9, a frame surrounding an inner space (e.g., the inner space 300 of FIGS. 3A and 3B) is described. Embodiments of the disclosure are not limited thereto. In the example of FIG. 10, the first frame 230c (e.g., the first frame 230a of FIG. 2B) and the second frame 240d (e.g., the second frame 240b of FIG. 2B) may include coupling members (e.g., the first coupling member 330 of FIG. 3A and the second coupling member 340 of FIG. 3B). For example, the first frame 230c may be integrally formed with the first coupling member 330a. At least a portion of the inner wall (e.g., the inner space 300 of FIGS. 3A and 3B) of the first frame 230c may be formed by the first coupling member 330a and the second coupling member (not illustrated) on the second circuit board 220. In the example of FIG. 10, when viewed on the X-Y plane, a partial section of the first frame 230c may be constituted by the first coupling member 330a. Similarly, a partial section of the second frame 240d may include a second coupling member (not illustrated) coupled to the first coupling member 330a.

The first frame 230c and the second frame 230d may be coupled to each other through the first coupling member 330a and the second coupling member (not illustrated). The first coupling member 330a and the second coupling member may be referred to by the description of the first coupling member 330 and the second coupling member 340 described above with reference to FIGS. 2A to 9, respectively, except for the structure of the frame.

As described above with respect to FIGS. 2A-9, conductive members and/or shielding members for electrical and/or magnetic shielding may be located at the inner walls of the frames (the first frame 230c and the second frame 240d).

In the example of FIG. 10, since the inner wall (e.g., the surface facing the inner space) of the coupling member (e.g., the first coupling member 330a) is used as the inner wall of the frame, the thickness of the frame may be reduced.

Fig. 11 is a block diagram illustrating an electronic device 1101 in a network environment 1100 according to various embodiments. Referring to Fig. 11, the electronic device 1101 in the network environment 1100 may communicate with an electronic device 1102 via a first network 1198 (e.g., a short-range wireless communication network), or at least one of an electronic device 1104 or a server 1108 via a second network 1199 (e.g., a long-range wireless communication network). According to an embodiment, the electronic device 1101 may communicate with the electronic device 1104 via the server 1108. According to an embodiment, the electronic device 1101 may include a processor 1120, memory 1130, an input module 1150, a sound output module 1155, a display module 1160, an audio module 1170, a sensor module 1176, an interface 1177, a connecting terminal 1178, a haptic module 1179, a camera module 1180, a power management module 1188, a battery 1189, a communication module 1190, a subscriber identification module(SIM) 1196, or an antenna module 1197. In some embodiments, at least one of the components (e.g., the connecting terminal 1178) may be omitted from the electronic device 1101, or one or more other components may be added in the electronic device 1101. In some embodiments, some of the components (e.g., the sensor module 1176, the camera module 1180, or the antenna module 1197) may be implemented as a single component (e.g., the display module 1160).

The processor 1120 may execute, for example, software (e.g., a program 1140) to control at least one other component (e.g., a hardware or software component) of the electronic device 1101 coupled with the processor 1120, and may perform various data processing or computation. According to one embodiment, as at least part of the data processing or computation, the processor 1120 may store a command or data received from another component (e.g., the sensor module 1176 or the communication module 1190) in volatile memory 1132, process the command or the data stored in the volatile memory 1132, and store resulting data in non-volatile memory 1134. According to an embodiment, the processor 1120 may include a main processor 1121 (e.g., a central processing unit (CPU) or an application processor (AP)), or an auxiliary processor 1123 (e.g., a graphics processing unit (GPU), a neural processing unit (NPU), an image signal processor (ISP), a sensor hub processor, or a communication processor (CP)) that is operable independently from, or in conjunction with, the main processor 1121. For example, when the electronic device 1101 includes the main processor 1121 and the auxiliary processor 1123, the auxiliary processor 1123 may be adapted to consume less power than the main processor 1121, or to be specific to a specified function. The auxiliary processor 1123 may be implemented as separate from, or as part of the main processor 1121.

The auxiliary processor 1123 may control at least some of functions or states related to at least one component (e.g., the display module 1160, the sensor module 1176, or the communication module 1190) among the components of the electronic device 1101, instead of the main processor 1121 while the main processor 1121 is in an inactive (e.g., sleep) state, or together with the main processor 1121 while the main processor 1121 is in an active state (e.g., executing an application). According to an embodiment, the auxiliary processor 1123 (e.g., an image signal processor or a communication processor) may be implemented as part of another component (e.g., the camera module 1180 or the communication module 1190) functionally related to the auxiliary processor 1123. According to an embodiment, the auxiliary processor 1123 (e.g., the neural processing unit) may include a hardware structure specified for artificial intelligence model processing. An artificial intelligence model may be generated by machine learning. Such learning may be performed, e.g., by the electronic device 1101 where the artificial intelligence is performed or via a separate server (e.g., the server 1108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 1130 may store various data used by at least one component (e.g., the processor 1120 or the sensor module 1176) of the electronic device 1101. The various data may include, for example, software (e.g., the program 1140) and input data or output data for a command related thererto. The memory 1130 may include the volatile memory 1132 or the non-volatile memory 1134.

The program 1140 may be stored in the memory 1130 as software, and may include, for example, an operating system (OS) 1142, middleware 1144, or an application 1146.

The input module 1150 may receive a command or data to be used by another component (e.g., the processor 1120) of the electronic device 1101, from the outside (e.g., a user) of the electronic device 1101. The input module 1150 may include, for example, a microphone, a mouse, a keyboard, a key (e.g., a button), or a digital pen (e.g., a stylus pen).

The sound output module 1155 may output sound signals to the outside of the electronic device 1101. The sound output module 1155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 1160 may visually provide information to the outside (e.g., a user) of the electronic device 1101. The display module 1160 may include, for example, a display, a hologram device, or a projector and control circuitry to control a corresponding one of the display, hologram device, and projector. According to an embodiment, the display module 1160 may include a touch sensor adapted to detect a touch, or a pressure sensor adapted to measure the intensity of force incurred by the touch.

The audio module 1170 may convert a sound into an electrical signal and vice versa. According to an embodiment, the audio module 1170 may obtain the sound via the input module 1150, or output the sound via the sound output module 1155 or a headphone of an external electronic device (e.g., an electronic device 1102) directly (e.g., wiredly) or wirelessly coupled with the electronic device 1101.

The sensor module 1176 may detect an operational state (e.g., power or temperature) of the electronic device 1101 or an environmental state (e.g., a state of a user) external to the electronic device 1101, and then generate an electrical signal or data value corresponding to the detected state. According to an embodiment, the sensor module 1176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 1177 may support one or more specified protocols to be used for the electronic device 1101 to be coupled with the external electronic device (e.g., the electronic device 1102) directly (e.g., wiredly) or wirelessly. According to an embodiment, the interface 1177 may include, for example, a high definition multimedia interface (HDMI), a universal serial bus (USB) interface, a secure digital (SD) card interface, or an audio interface.

A connecting terminal 1178 may include a connector via which the electronic device 1101 may be physically connected with the external electronic device (e.g., the electronic device 1102). According to an embodiment, the connecting terminal 1178 may include, for example, a HDMI connector, a USB connector, a SD card connector, or an audio connector (e.g., a headphone connector).

The haptic module 1179 may convert an electrical signal into a mechanical stimulus (e.g., a vibration or a movement) or electrical stimulus which may be recognized by a user via his tactile sensation or kinesthetic sensation. According to an embodiment, the haptic module 1179 may include, for example, a motor, a piezoelectric element, or an electric stimulator.

The camera module 1180 may capture a still image or moving images. According to an embodiment, the camera module 1180 may include one or more lenses, image sensors, image signal processors, or flashes.

The power management module 1188 may manage power supplied to the electronic device 1101. According to one embodiment, the power management module 1188 may be implemented as at least part of, for example, a power management integrated circuit (PMIC).

The battery 1189 may supply power to at least one component of the electronic device 1101. According to an embodiment, the battery 1189 may include, for example, a primary cell which is not rechargeable, a secondary cell which is rechargeable, or a fuel cell.

The communication module 1190 may support establishing a direct (e.g., wired) communication channel or a wireless communication channel between the electronic device 1101 and the external electronic device (e.g., the electronic device 1102, the electronic device 1104, or the server 1108) and performing communication via the established communication channel. The communication module 1190 may include one or more communication processors that are operable independently from the processor 1120 (e.g., the application processor (AP)) and supports a direct (e.g., wired) communication or a wireless communication. According to an embodiment, the communication module 1190 may include a wireless communication module 1192 (e.g., a cellular communication module, a short-range wireless communication module, or a global navigation satellite system (GNSS) communication module) or a wired communication module 1194 (e.g., a local area network (LAN) communication module or a power line communication (PLC) module). A corresponding one of these communication modules may communicate with the external electronic device via the first network 1198 (e.g., a short-range communication network, such as Bluetooth^{™}, wireless-fidelity (Wi-Fi) direct, or infrared data association (IrDA)) or the second network 1199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 1192 may identify and authenticate the electronic device 1101 in a communication network, such as the first network 1198 or the second network 1199, using subscriber information (e.g., international mobile subscriber identity (IMSI)) stored in the subscriber identification module 1196.

The wireless communication module 1192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 1192 may support a high-frequency band (e.g., the mmWave band) to achieve, e.g., a high data transmission rate. The wireless communication module 1192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 1192 may support various requirements specified in the electronic device 1101, an external electronic device (e.g., the electronic device 1104), or a network system (e.g., the second network 1199). According to an embodiment, the wireless communication module 1192 may support a peak data rate (e.g., 20Gbps or more) for implementing eMBB, loss coverage (e.g., 1164dB or less) for implementing mMTC, or U-plane latency (e.g., 0.5ms or less for each of downlink (DL) and uplink (UL), or a round trip of 11ms or less) for implementing URLLC.

The antenna module 1197 may transmit or receive a signal or power to or from the outside (e.g., the external electronic device) of the electronic device 1101. According to an embodiment, the antenna module 1197 may include an antenna including a radiating element composed of a conductive material or a conductive pattern formed in or on a substrate (e.g., a printed circuit board (PCB)). According to an embodiment, the antenna module 1197 may include a plurality of antennas (e.g., array antennas). In such a case, at least one antenna appropriate for a communication scheme used in the communication network, such as the first network 1198 or the second network 1199, may be selected, for example, by the communication module 1190 (e.g., the wireless communication module 1192) from the plurality of antennas. The signal or the power may then be transmitted or received between the communication module 1190 and the external electronic device via the selected at least one antenna. According to an embodiment, another component (e.g., a radio frequency integrated circuit (RFIC)) other than the radiating element may be additionally formed as part of the antenna module 1197.

According to various embodiments, the antenna module 1197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an interperipheral communication scheme (e.g., a bus, general purpose input and output (GPIO), serial peripheral interface (SPI), or mobile industry processor interface (MIPI)).

According to an embodiment, commands or data may be transmitted or received between the electronic device 1101 and the external electronic device 1104 via the server 1108 coupled with the second network 1199. Each of the electronic devices 1102 or 1104 may be a device of a same type as, or a different type, from the electronic device 1101. According to an embodiment, all or some of operations to be executed at the electronic device 1101 may be executed at one or more of the external electronic devices 1102, 1104, or 1108. For example, if the electronic device 1101 should perform a function or a service automatically, or in response to a request from a user or another device, the electronic device 1101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 1101. The electronic device 1101 may provide the outcome, with or without further processing of the outcome, as at least part of a reply to the request. To that end, a cloud computing, distributed computing, mobile edge computing (MEC), or client-server computing technology may be used, for example. The electronic device 1101 may provide ultra low-latency services using, e.g., distributed computing or mobile edge computing. In another embodiment, the external electronic device 1104 may include an internet-of-things (IoT) device. The server 1108 may be an intelligent server using machine learning and/or a neural network. According to an embodiment, the external electronic device 1104 or the server 1108 may be included in the second network 1199. The electronic device 1101 may be applied to intelligent services (e.g., smart home, smart city, smart car, or healthcare) based on 5G communication technology or IoT-related technology.

In an embodiment, the electronic device 1001 may include at least one printed circuit board (e.g., the first circuit board 151 and/or the second circuit board 152 of FIG. 1D). For example, the printed circuit board may include a printed circuit structure.

According to an embodiment, the circuit board structure (e.g., the circuit board structure 200 of FIGS. 2A and 2B) may include a first circuit board (e.g., the first circuit board 210 of FIG. 2A) including a first surface, and a second circuit board (e.g., the second circuit board 220 of FIG. 2A) including a second surface facing the first surface. The circuit board structure may include a plurality of first coupling members (e.g., the first coupling member 330 of FIG. 3A) coupled to the first surface, and a plurality of second coupling members (e.g., a second coupling member 340 of FIG. 3B) coupled to the second surface and configured to be physically coupled with the plurality of first coupling members. The circuit board structure may include a frame (e.g., the first frame 230 of FIG. 3A and the second frame 240 of FIG. 3B), which extends between the first surface and the second surface and includes a plurality of openings (e.g., the openings 270 of FIG. 3A and the openings 280 of FIG. 3B) configured to accommodate the plurality of first coupling members and the plurality of second coupling members. The plurality of first coupling members and the second coupling members may provide an electrical connection between the first circuit board and the second circuit board.

For example, the first surface, the second surface, and the frame may be set to form at least a portion of an inner space (e.g., the inner space 300 of FIGS. 3A and 3B) of the circuit board structure. The frame may include an inner wall facing the inner space. The inner wall may be located between the inner space and a coupling member including the plurality of first coupling members and the plurality of second coupling members. The plurality of openings may include a first opening set to accommodate a first coupling member among the plurality of first coupling members and a second coupling member among the plurality of second coupling members. The first opening may be formed by an inner wall of the frame located at a peripheral region of the first coupling member and the second coupling member adjacent to the inner space, a first sidewall extending from the inner space toward the outside of the circuit board structure at a first point P1 of the inner wall, and a second sidewall extending from the inner space to the outside of the circuit board structure at a second point P2 of the inner wall. The first opening may be formed to surround the periphery of the first coupling member and the second couple member when viewed from above the first circuit board toward the second circuit board.

In one example, the circuit board structure may further include a shielding member (e.g., 600, 610a, 610b, 610c, 620a, 620b, 620c of FIGS. 6A to 6D) positioned adjacent the inner wall and configured to provide electromagnetic shielding for the inner space. For example, the shielding member may be attached to the inner wall. For example, the shielding member includes a first shielding member coupled to the first surface and a second shielding member coupled to the second surface, and the first shielding member may be configured to be couple with the second shielding member.

In an example, the circuit board structure may further include a connecting member (e.g., the connecting member 710 of FIG. 7) including a first end disposed between the first circuit board and a first coupling member among the plurality of coupling members and a second end electrically connected to an electrical component (e.g., the electrical element 711 of FIG. 7). The connecting member may include a plurality of vias (e.g., the first electrical path 811 of FIG. 8A) configured to electrically connect the first coupling member to the first circuit board and a plurality of conductive paths (e.g., the second electrical path 813 of FIG. 8A) that electrically connect the electrical component to the first circuit board.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 1140) including one or more instructions that are stored in a storage medium (e.g., internal memory 1136 or external memory 1138) that is readable by a machine (e.g., the electronic device 1101). For example, a processor (e.g., the processor 1120) of the machine (e.g., the electronic device 1101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. A circuit board structure (200) including:
a first circuit board (210) including a first surface;
a second circuit board (220) including a second surface facing the first surface;
a plurality of first coupling members (330) coupled at the first surface;
a plurality of second coupling members (340) coupled at the second surface and configured to be physically coupled with the plurality of first coupling members; and
a frame (230, 240) extended between the first surface and the second surface, and including a plurality of openings (270, 280) configured to accommodate the plurality of first coupling members and the plurality of second coupling members,
wherein the plurality of first coupling members and the plurality of second coupling members are configured to provide electrical connections between the first circuit board and the second circuit board.

2. The circuit board structure of claim 1, wherein the first surface, the second surface, and the frame are configured to form at least a part of an inner space 300 of the circuit board structure.

3. The circuit board structure of claim 2,
wherein the frame includes an inner wall facing the inner space, and
wherein the inner wall is located between the inner space and coupling members including the plurality of first coupling members and the plurality of second coupling members.

4. The circuit board structure of claim 3, further including a shielding member (600, 610a, 610b, 610c, 620a, 620b, 620c) located to be adjacent to the inner wall and configured to provide electrical shielding to the inner space.

5. The circuit board structure of claim 4, wherein the shielding member is attached to the inner wall.

6. The circuit board structure of claim 4,
wherein the shielding member includes:
a first shielding member coupled to the first surface, and
a second shielding member coupled to the second surface, and
wherein the first shielding member is configured to be coupled with the second shielding member.

7. The circuit board structure of claim 2,
wherein the plurality of openings include:
a first opening configured to accommodate a first coupling member of the plurality of first coupling members, and
a second coupling member of the plurality of second coupling members, and
wherein the first opening is formed by:
an inner wall of the frame, the inner wall being located at a peripheral area of the first coupling member and the second coupling member and the peripheral area being adjacent to the inner space,
a first side wall extending from a first point (P1) of the inner wall in a direction from the inner space toward an exterior of the circuit board structure; and
a second side wall extending from a second point (P2) of the inner wall in a direction from the inner space toward the exterior of the circuit board structure.

8. The circuit board structure of claim 7, wherein the first opening, when viewed from above the first circuit board toward the second circuit board, is configured to surround a periphery of the first coupling member and the second coupling member.

9. The circuit board structure of claim 1, further including:
a connection member 710 including a first end and a second end, the first end being disposed between the first circuit board and a first coupling member among the plurality of the first coupling members and the second end being electrically connected with an electrical component 711,
wherein the connection member includes:
a plurality of vias configured to electrically connect the first coupling member to the first circuit board, and
a plurality of conductive paths configured to electrically connect the electrical component to the first circuit board.

10. An electronic device including a circuit board structure (200), the circuit board structure including:
a first circuit board (210) including a first surface;
a second circuit board (220) including a second surface facing the first surface;
a plurality of first coupling members (330) coupled at the first surface;
a plurality of second coupling members (340) coupled at the second surface and configured to be physically coupled with the plurality of first coupling members; and
a frame (230, 240) extended between the first surface and the second surface, and including a plurality of openings (270, 280) configured to accommodate the plurality of first coupling members and the plurality of second coupling members,
wherein the plurality of first coupling members and the plurality of second coupling members are configured to provide electrical connections between the first circuit board and the second circuit board.

11. The electronic device of claim 10, wherein the first surface, the second surface, and the frame are configured to form at least a part of an inner space 300 of the circuit board structure.

12. The electronic device of claim 11,
wherein the frame includes an inner wall facing the inner space, and
wherein the inner wall is located between the inner space and coupling members including the plurality of first coupling members and the plurality of second coupling members.

13. The electronic device of claim 12, further including a shielding member (600, 610a, 610b, 610c, 620a, 620b, 620c) located to be adjacent to the inner wall and configured to provide electrical shielding to the inner space.

14. The electronic device of claim 13, wherein the shielding member is attached to the inner wall.

15. The electronic device of claim 13,
wherein the shielding member includes:
a first shielding member coupled to the first surface, and
a second shielding member coupled to the second surface, and
wherein the first shielding member is configured to be coupled with the second shielding member.
